## Europäisches Patentamt
## European Patent Office
## Office européen des brevets

(19)

(11) Numéro de publication: **0 030 167**
**B1**

(12)

# FASCICULE DE BREVET EUROPEEN

(45) Date de publication du fascicule du brevet:
20.07.83

(51) Int. Cl.³: **H 05 K 3/36**

(21) Numéro de dépôt: **80401428.0**

(22) Date de dépôt: **07.10.80**

(54) **Dispositif de connexion pour le multiplexage de microcircuits électroniques, et tête de lecture-écriture et panneau d'affichage utilisant ce procédé.**

(30) Priorité: **23.11.79 FR 7928978**

(43) Date de publication de la demande:
**10.06.81 Bulletin 81/23**

(45) Mention de la délivrance du brevet:
**20.07.83 Bulletin 83/29**

(84) Etats contractants désignés:
**DE GB NL**

(56) Documents cités:
**FR-A-1 515 936**
**US-A-3 615 949**
**US-A-4 141 075**

(73) Titulaire: **THOMSON-CSF, 173, Boulevard Haussmann, F-75379 Paris Cedex 08 (FR)**

(72) Inventeur: **Val, Christian, "THOMSON-CSF" SCPI-173, bld Haussmann, F-75360 Paris Cedex 08 (FR)**
Inventeur: **Vergnolle, Claude, "THOMSON-CSF" SCPI-173, bld Haussmann, F-75360 Paris Cedex 08 (FR)**

(74) Mandataire: **Giraud, Pierre et al, THOMSON-CSF SCPI 173, Bld Haussmann, F-75379 Paris Cedex 08 (FR)**

ACTORUM AG

## Dispositif de connexion pour le multiplexage de microcircuits électroniques, et tête de lecture-écriture et panneau d'affichage utilisant ce procédé

L'invention concerne un dispositif de connexion d'usage général, mais plus particulièrement destiné aux systèmes répétitifs, lesquels nécessitent normalement un multiplexage entre les organes de commande et les organes commandés. Dans ces systèmes, les conducteurs électriques sont répartis sur deux niveaux au moins de support, en raison des croisements entre conducteurs : le dispositif de connexion de multiplexage selon l'invention apporte l'avantage de n'utiliser qu'un seul niveau de conducteur.

Les systèmes dits répétitifs concernés par l'invention sont, à titre d'exemple, des dispositifs d'affichage par diodes électroluminescentes ou par panneau à plasma, les dispositifs d'écriture par résistances chauffantes ou encore les mémoires complexes comportant une partie câblée et des circuits intégrés d'entrée et de sortie. D'autres exemples peuvent encore être cités comme illustration de l'invention sans pour autant sortir du cadre de l'invention.

Les points communs à tous ces dispositifs répétitifs sont que, en premier lieu, ils comportent des éléments commandés de grande taille et rigides — tels que panneaux d'affichage, têtes d'écriture ou de lecture — qui sont réunis, par de très nombreux conducteurs, à des éléments de commande de petites tailles — pastilles de circuits intégrés le plus souvent —, et que, en second lieu, les conducteurs électriques qui sont distribués en lignes et en colonnes se croisent entre eux et avec les conducteurs électriques communs d'alimentation ou de commande, ce qui nécessite généralement une connectique à plusieurs niveaux.

On appelle connectique l'art de réunir entre eux les différents composants d'un système électronique, composants dont les technologies et les fonctions peuvent être très différentes, allant de la fibre optique jusqu'au système complet.

La différence des dimensions entre les éléments commandés et les éléments de commande dans un dispositif du type répétitif intervient dans la difficulté qui existe réellement à trouver une technologie commune pour effectuer les connexions : à titre d'exemple, les circuits imprimés ou les câbles plats multifilaires — appelés également limandes — conviennent pour être reliés et connectés à une tête d'impression ou à un panneau d'affichage, mais ne conviennent pas pour être soudés sur une pastille de circuit intégré, si ce n'est par le moyen d'intermédiaires, qui compliquent le montage, en augmentant le prix et en diminuent la fiabilité.

Par ailleurs, les systèmes de connexions à plusieurs niveaux de conducteurs métalliques séparés par des couches d'isolants, que ce soient des circuits imprimés multicouches, rigides ou souples, ou que ce soient des substrats céramiques multicouches tels que ceux utilisés en circuits hybrides, sont toujours délicats à mettre en œuvre, par exemple en raison des trous métallisés et des prises de contact avec une couche interne, et leur structure les rend de toute façon coûteux.

Par exemple, est connu du brevet USA No 3615649 un composant de croisement de conducteurs pour réseaux à grande échelle. Ce composant, qui se présente comme un microboîtier plat muni de connexions extérieures, comporte un substrat isolant sur lequel sont déposés des métallisations correspondant aux conducteurs qui doivent se croiser. Mais ces métallisations sont séparées en deux groupes. Un premier groupe de métallisations assure un contact ohmique entre bornes d'entrée-sortie associées directement dans le plan de ces métallisations. Un second groupe de métallisations, interrompues dans le plan du premier groupe, sont rétablies dans un second plan, isolé du premier par une couche isolante. Les croisements entre conducteurs sont donc réalisés en associant un substrat à une seule couche de conducteurs et un ou plusieurs composants de petites dimensions, à plusieurs couches de conducteurs isolées par des couches isolantes.

Un tel composant constitue donc un réseau de croisements entre conducteurs.

Le problème des croisements entre conducteurs est à ce point crucial que, dans les catalogues de nombreux fournisseurs de semi-conducteurs, existent des circuits intégrés de matrices de points de croisement avec décodeurs d'adresse et mémoires éventuellement.

L'utilisation de tels circuits intégrés de points de croisement est tout à fait justifiée dans des matériels professionnels tels que l'informatique ou les télécommunications, mais ne l'est plus dans le cas où le matériel à réaliser est à destination du grand public, pour deux raisons : le supplément de prix du circuit multicouche économisé est annulé par le supplément de prix du circuit intégré qui le remplace et, du point de vue technologique, un boîtier de circuit intégré supplémentaire n'est pas une solution heureuse.

Parmi les moyens connus de montage de pastilles nues de circuits intégrés, le procédé TAB (Transfert Automatique sur Bandes ou Tape Automatic Bonding) utilise un support du type des films photographiques, sur lequel est déposé le réseau de conducteurs métalliques : toutes les soudures des conducteurs sur les pastilles de circuits intégrés sont effectuées simultanément, par soudure collective. La titulaire a déposé le 12 septembre 1977 une demande de brevet français FR-A No 2402995 pour un procédé selon lequel le film en polyester qui sert de support aux conducteurs métalliques soudés sur la ou les pastilles de circuits intégrés dans le procédé de montage TAB n'est plus éliminé après l'opération de soudure collective, mais est conservé en tant que support souple des pastilles de circuit intégré encapsulées sur place.

L'invention part de ce procédé, selon lequel un grand nombre de pastilles de circuits intégrés peuvent être supportées sur un film de type photographique et protégées par les boîtiers qui sont rapportés, et complète ce procédé, d'une part, en réalisant les croisements de conducteurs à la surface des pastilles de circuits intégrés par une métallisation supplémentaire rapportée sur une coche isolante supplémentaire et, d'autre part, en effectuant les multiplexages sur au moins une extrémité de film TAB, coupée en biais et soudée sur un second film TAB. L'ensemble du film supportant les pastilles de circuits intégrés des composants annexes éventuels, et des connexions métalliques, constitue un circuit hybride souple directement utilisé pour la connectique.

De façon plus précise, l'invention consiste en un dispositif de connexion pour le multiplexage de microcircuits électroniques de commande en liaison bidirectionnelle avec des éléments commandés, caractérisé en ce que le moyen de multiplexage est constitué par un circuit hybride souple à un seul niveau de conducteurs, et en ce que les conducteurs d'alimentation sont distribués d'un premier microcircuit vers d'autres microcircuits au moyen de métallisations en pont, déposées sur une couche isolante supplémentaire à la surface des microcircuits de commande.

L'invention et un certain nombre de ses avantages seront mieux compris par la description qui va en être faite, laquelle s'appuie sur un exemple de tête d'écriture pour imprimante, et sur les figures qui l'accompagnent, lesquelles représentent:

— la fig. 1, un exemple de connectique selon l'art connu;

— la fig. 2, un exemple de connectique selon l'invention;

— la fig. 3, une pastille de circuit intégré modifiée selon l'invention;

— la fig. 4, une interconnexion de multiplexage selon l'invention.

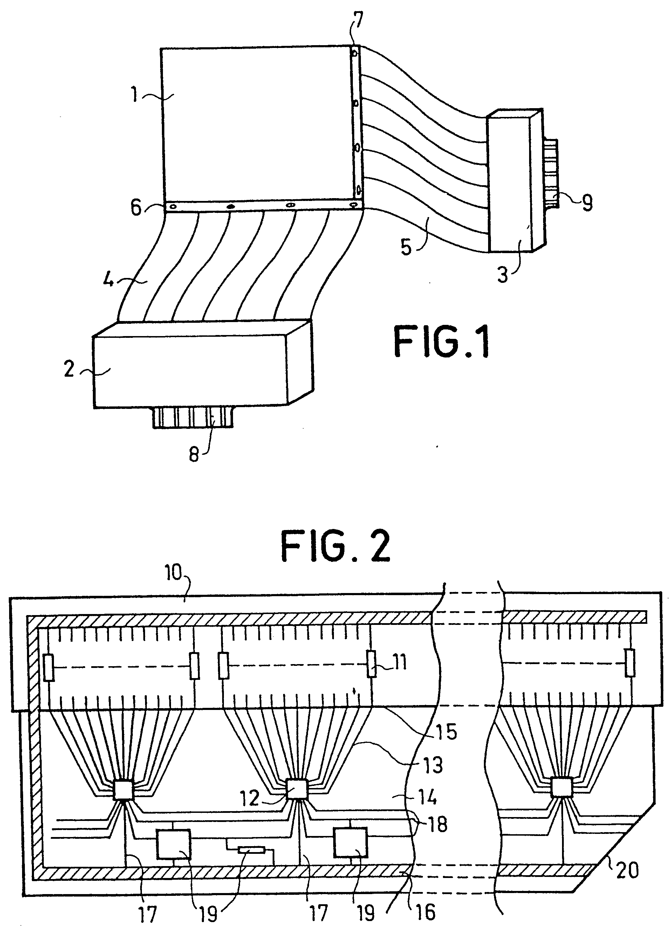

La fig. 1 représente un exemple de connectique selon l'art connu.

Dans ce dispositif répétitif, l'élément commandé 1, qui peut être par exemple un panneau à plasma ou une tête de lecture/écriture, est commandé par une électronique de commande montée sur un circuit imprimé 2 pour les éléments en colonne dans le panneau 1 et par un circuit imprimé 3 pour les éléments en ligne du panneau 1. L'électronique de commande des colonnes est reliée à l'élément commandé 1 par un circuit d'interconnexion, tandis que l'électronique de commande des lignes est reliée par un circuit d'interconnexion souple 5.

Ces deux circuits souples sont connectés sur le panneau par pression mécanique au moyen de barrettes vissées 6 et 7 qui assurent le maintien des conducteurs portés sur le circuit souple contre les conducteurs correspondants portés par le panneau 1. Les liaisons extérieures des électroniques de commandes 2 et 3 sont assurées par des cartes enfichables ou par des connecteurs 8 et 9.

Cette connectique selon l'art connu a l'inconvénient d'occuper un volume assez important en raison, en particulier, des circuits souples assimilables aux conducteurs plats multifilaires dits limandes et en raison de l'encombrement des circuits imprimés 2 et 3.

La fig. 2 représente un exemple de connectique selon l'invention. Pour concrétiser l'invention, on a choisi le cas, cité à titre d'exemple non limitatif, d'une tête d'impression thermique pour imprimante périphérique en informatique.

La tête d'impression thermique 10 comporte un grand nombre, de l'ordre du millier, d'éléments chauffants 11, qui sont symboliquement représentés par des résistances. Lorsque ces éléments chauffants sont parcourus par un courant, ils impriment une trace thermique sur le papier. Les éléments chauffants sont commandés par l'intermédiaire d'une électronique qui, actuellement, est très généralement constituée par des circuits intégrés dont les pastilles 12 sont réunies aux éléments chauffants 11 par des connexions 13. Ces pastilles de circuits intégrés sont montées, selon le procédé TAB, sur un film souple 14 directement soudé en 15 sur le bord de la barrette chauffante de la tête thermique. Le nombre de soudures qui réunit les conducteurs électriques 13 issus de pastilles de circuits intégrés à autant d'éléments chauffants 11 est suffisant pour que le maintien mécanique soit excellent et qu'il ne soit pas utile de recourir à des cadres exerçant une pression ou vissés dans la tête d'imprimante 10.

Sur le support souple 14, un certain nombre de connexions électriques sont communes aux différents circuits intégrés et assurent le multiplexage. A titre d'exemple, citons une connexion 16 qui correspond à la masse commune à tous les circuits intégrés et au retour de courant à travers les résistances 11. Cette bande de connexion comporte une dérivation 17 à hauteur de chaque pastille de circuit intégré pour assurer une masse commune à tous les circuits intégrés. Il y a également un certain nombre de conducteurs tels que 18 qui correspondent, par exemple, à l'alimentation des circuits intégrés, à un signal d'horloge ou encore à un signal de remise à zéro: ces connexions 18 parcourent la surface du film 14 et desservent la totalité des pastilles de circuit intégré 12. Il s'ensuit que, si plusieurs bandes de connexions 18 sont réunies à une pastille de circuit intégré et doivent ensuite être réunies à une autre pastille voisine, il y a obligatoirement croisement de conducteurs.

Des composants discrets 19, tels que conducteurs de découplage, ou résistances d'équilibrage, peuvent être disposés par-dessus des bandes de connexions 18 sans inconvénients.

Un premier objet de l'invention est d'éviter à la fois qu'il y ait croisement de conducteurs sur la surface du film souple 14, ce qui court-circuiterait les signaux électroniques, mais également que ce film soit multicouhe, ce qui le rendrait plus coûteux. Pour cela, les conducteurs qui desservent une pastille de circuit intégré franchissent les autres conducteurs, avec lesquels ils ne doivent pas avoir de point commun, au moyen de ponts qui sont réalisés par des conducteurs métalliques disposés à la surface des pastilles de circuits intégrés et qui sont isolés de la partie active du substrat du circuit intégré par une couche d'isolant supplémentaire intercalée entre le circuit intégré à proprement parler et l'interconnexion déposée à sa surface.

Le multiplexage, entre plusieurs éléments, par une extrémité biaisée 20 sera exposé ultérieurement.

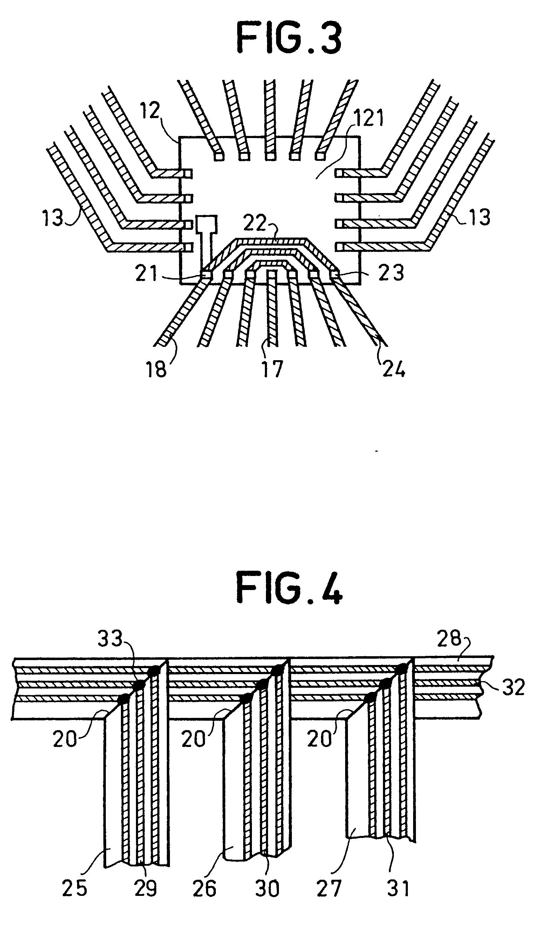

La fig. 3 représente une pastille de circuit intégré modifiée pour réaliser la connectique selon l'invention.

La pastille 12 de circuit intégré est réunie aux éléments actifs du dispositif d'affichage ou de lecture par des bandes conductrices 13 qui sont soudées collectivement selon le procédé TAB sur les plots de connexion répartis à la surface et sur le bord de la pastille. Parmi les plots de connexion, un certain nombre correspond à des signaux électriques d'entrée dans le circuit intégré, c'est-à-dire alimentation, masse, horloge, etc., signaux qui desservent plusieurs circuits intégrés. Ainsi, sur un côté de la pastille 12 représentée en fig. 3, figurent une bande de connexion 17 qui correspond à la masse et l'une des bandes de connexion 18 qui est soudée sur un plot de connexion 21 en liaison avec un élément actif du circuit intégré, par exemple un transistor.

Une pluralité de bandes de connexions telles que 17 et 18 doit donc desservir une pluralité de pastilles de circuits intégrés qui, en raison du caractère linéaire du dispositif commandé — tête d'imprimante thermique, ou ligne d'un panneau d'affichage — sont eux-mêmes disposés en ligne. Il y a donc un problème de croisements entre conducteurs, qui ne peut pas être résolu par un circuit multicouche, puisque le substrat du réseau des conducteurs est un film souple monocouche.

Les croisements entre bandes de connexions sont résolus, selon l'invention, par une modification de la surface des pastilles de circuits intégrés. Chaque pastille de circuit intégré 12 reçoit, à l'issue de sa fabrication, une couche isolante 121 déposée sur sa surface; cette couche isolante est ensuite gravée pour dégager les plots de connexion de la pastille, sur lesquels sera soudée l'araignée de bandes de connexion 13 selon le procédé TAB. Puis la couche isolante 121 est métallisée et gravée, de façon à former autant de ponts métalliques, tels que 22, qu'il y a de croisements de conducteurs à éviter. Chaque pont métallique 22 relie une borne 21, à laquelle aboutit une bande de connexion 18, à une borne 23, d'où repart une bande de connexion 24, qui va alimenter un autre circuit intégré. Par conséquent, la bande de connexion 24 soudée sur la borne 23 est en contact ohmique avec la bande de connexion 18 soudée sur la borne 21, car elles sont réunies par une métallisation 22, supportée par la couche 121.

Ce type de connexion à la surface d'un circuit intégré permet l'alimentation de circuits intégrés dans la mesure où l'intensité qui traverse ces bandes métallisées n'est pas trop importante et dans la mesure où, dans ces conditions, les bornes métallisées ne font pas effet de fusible en cas de surintensité, le cas le plus général avec les circuits intégrés actuels qui consomment peu et pour lesquels les signaux d'horloge ou de remise à zéro sont sous des intensités extrêmement faibles.

La connectique qui vient d'être décrite concerne un élément linéaire d'un dispositif complexe, lequel peut, dans certains cas, par exemple pour des panneaux d'affichage, comporter plusieurs dispositifs voisins les uns des autres. Il importe dans ce cas que les connexions communes telles qu'alimentation, masse, signal d'horloge, signal de remise à zéro et d'autres encore, soient distribuées aux différentes lignes du dispositif complexe; il s'agit donc d'un problème de multiplexage.

Dans ce cas, le film 14 qui, sur la fig. 2, est un support de connexion pour un dispositif élémentaire, est coupé en biais dans un angle selon une ligne 20 qui recoupe les différentes bandes de conducteurs tels que 16 et 18. Un second film souple comparable au premier film 14, et qui porte également sur sa surface des bandes de conducteurs métalliques correspondant aux précédents conducteurs tels que 16 et 18, est disposé sous le précédent selon un angle préférentiellement égal à 90°. La distribution des tensions de commande: alimentation, masse, horloge, etc., se fait soit par pontage, soit par refusion d'une goutte de soudure à l'intersection entre les connexions portées par le premier film 14 et les connexions portées par le second film souple; le contact électrique est donc établi par les points de soudure.

La fig. 4 représente un exemple du multiplexage entre plusieurs circuits souples monocouches selon l'invention.

On peut considérer que ls circuits souples 25, 26 et 27 desservent, par exemple, chacun une ligne d'un dispositif d'affichage, et que leur ensemble interconnecté au moyen d'un circuit souple 28 permet de commander simultanément plusieurs colonnes de ce dispositif d'affichage. Seules ont été représentées sur cette figure les extrémités des circuits souples tels que définis par l'indice 14 sur la fig. 2. Les circuits intégrés de commande et les organes commandés n'y sont pas représentés. Chacun des circuits souples monocouches 25, 26, 27 et 28 supporte un certain nombre de connexions électriques sous la forme d'un dépôt métallique, généralement en cuivre, adhérant à la surface du circuit souple. Sur cette figure, les bandes 29, 30, 31 et 32 correspondent à la distribution du même signal électrique dans différentes lignes ou colonnes du dispositif. Les circuits souples 25, 26 et 27 découpés selon une droite en biais 20 par rapport aux connexions électriques sont pressés contre le circuit souple 28: le passage du courant depuis une bande de connexion telle que 29 jusqu'à une bande de connexion telle que 32 qui lui correspond est assuré par une goutte de soudure telle que 33 qui coule le long du bord découpé en biais de la bande souple 25.

L'invention a été décrite en s'appuyant sur le cas de dispositifs répétitifs tels que les panneaux d'affichage, ou des têtes de lecture ou d'écriture, et en supposant que l'électronique de commande est à base de circuits intégrés. Cela correspond à l'état actuel de la technique dans ce domaine de l'électronique. Cependant, l'invention s'applique également à tout autre dispositif nécessitant un multiplexage entre des liaisons électriques et n'utilisant pas obligatoirement des circuits intégrés. Le point commun à tous les dispositifs concernés par l'invention est que le circuit hybride souple qui suporte l'électronique de cmmande est directement soudé sur le moyen commandé, sans interposition d'aucun moyen mécanique de pression ou d'aucun connecteur supplémentaire, et qu'un ensemble de moyens de connexion permet le multiplexage, avec des circuits monocouches, sans avoir besoin de recourir aux circuits multicouches.

## Revendications

1. Dispositif de connexion de microcircuits électroniques de commande (12), multiplexés en liaison bidirectionnelle avec des éléments commandés (11), caractérisé en ce qu'il comporte:
— un circuit hybride souple (14), à un seul niveau de conducteurs (13, 18),
— une pluralité de microcircuits électroniques (12), supportés par le circuit souple (14) et réunis aux connexions (13) vers les éléments commandés (11),
— les conducteurs d'alimentation (18) de ces microcircuits étant distribués d'un premier microcircuit vers d'autres microcircuits par une modification en surface des pastilles de microcircuits, qui comprend l'adjonction d'une couche isolante supplémentaire (121), laquelle dégage les bornes de connexion préexistantes (21, 23) en surface du microcircuit (12), et l'adjonction de bandes métallisées (22), déposées sur la couche isolante, formant pont entre une borne d'entrée (21) et une borne de sortie (23) de chaque microcircuit (12).

2. Dispositif de connexion selon la revendication 1, caractérisé en ce que les ponts métalliques (22), à la surface des microcircuits, sont en liaison ohmique par au moins une borne de connexion (21), avec les éléments actifs du microcircuit (12).

3. Dispositif de connexion selon la revendication 2, caractérisé en ce que les ponts métalliques (22), à la surface des microcircuits, sont isolés des éléments actifs des microcircuits et interconnectent entre elles deux bornes de connexion, l'une d'entrée, l'autre de sortie, isolées du microcircuit.

4. Dispositif de connexion selon la revendication 1, caractérisé en ce que les microcircuits de commande (12) sont des circuits intégrés.

5. Dispositif de connexion selon la revendication 1, caractérisé en ce que les éléments commandés (11) sont des résistances chauffantes.

6. Dispositif de connexion selon la revendication 1, caractérisé en ce que les éléments (11) sont des photodiodes.

7. Dispositif de connexion selon la revendication 1, caractérisé en ce que les éléments commandés (11) sont des diodes à plasma.

8. Dispositif de connexion selon la revendication 1, caractérisé en ce que, en vue de former des assemblages d'éléments commandés, avec multiplexage de circuits hybrides souples (14) à un seul niveau de conducteurs, les circuits de distribution (25, 26, 27) sont coupés en biais (20) à l'une de leurs extrémités, posés sur un circuit d'alimentation (28) qui leur est perpendiculaire, et les conducteurs métalliques (29, 30, 31, 32) sont réunis, chacun à chacun, au moyen d'une liaison métallique (33).

9. Tête de lecture-écriture, caractérisée en ce qu'elle comporte au moins un dispositif de connexion selon l'une des revendications 1 à 8.

10. Panneau d'affichage, caractérisé en ce qu'il comporte au moins un dispositif de connexion selon l'une des revendications 1 à 8.

## Patentansprüche

1. Schaltvorrichtung für elektronische Steuerungsmikroschaltkreise (12), die in bidirektionneller Verknüpfung mit gesteuerten Elementen (11) multiplexiert sind, dadurch gekennzeichnet, dass sie umfasst:
— einen biegsamen hybriden Schaltkreis (14) mit einer einzelnen Leiterstelle (13, 18),
— eine Mehrzahl von elektronischen Mikroschaltkreisen (12), die durch den biegsamen Schaltkreis (14) gehalten werden und mit den an die gesteuerten Elementen (11) angeschlossenen Anschlussleitungen (13) verbunden sind,
— wobei die Stromzuführung (18) dieser Mikroschaltkreise von einem ersten Mikroschaltkreis aus durch eine Oberflächenveränderung der Mikroschaltplättchen auf weitere Mikroschaltkreise verteilt sind, welche Veränderung in der Anbringung einer die vorbestehenden Anschlussklemmen (21, 23) an der Oberfläche der Mikroschaltkreise (12) freilassenden zusätzlichen Isolierschicht (121) besteht, sowie in der Anbringung von metallisierten Streifen (22) auf der Isolierschicht, die zweischen einer Eingangsklemme (21) und einer Ausgangsklemme (23) eines jeden Mikroschaltkreises (12) je eine Brücke bilden.

2. Schaltvorrichtung gemäss Anspruch 1, dadurch gekennzeichnet, dass die sich an der Oberfläche der Mikroschaltkreise befindlichen Metallbrücken (22) über wenigstens eine Anschlussklemme (21) elektrisch mit den aktiven Elementen des Mikroschaltkreises (12) verbunden sind.

3. Schaltvorrichtung gemäss Anspruch 2, dadurch gekennzeichnet, dass dise sich an der Oberfläche der Mikroschaltkreise befindlichen Metallbrücken (22) von den aktiven Elementen der Mikroschalter isoliert sind und zwei von dem Mikroschaltkreis isolierte Anschlussklemmen, nämlich eine Eingangs- und eine Ausgangsklemme miteinander verbinden.

4. Schaltvorrichtung gemäss Anspruch 1, dadurch gekennzeichnet, dass die Steuermikroschaltkreise (12) integrierte Schaltkreise sind.

5. Schaltvorrichtung gemäss Anspruch 1, dadurch gekennzeichnet, dass die gesteuerten Elemente (11) Heizwiderstände sind.

6. Schaltvorrichtung gemäss Anspruch 1, dadurch gekennzeichnet, dass die gesteuerten Elemente (11) Photodioden sind.

7. Schaltvorrichtung gemäss Anspruch 1, dadurch gekennzeichnet, dass die gesteuerten Elemente (11) Plasmadioden sind.

8. Schaltvorrichtung gemäss Anspruch 1, dadurch gekennzeichnet, dass zwecks Bildung von aus gesteuerten Elementen bestehenden Baugruppen mit Multiplexierung flexibler hybrider Schaltkreise (14) an je einer einzigen Leiterstelle die Verteilerschaltkreise (25, 26, 27) an ihren Enden schräg geschnitten (20), auf einen zu ihnen senkrechten Speiseschaltkreis (28) gesetzt und durch eine metallische Verbindung (33) alle metallischen Leiter (29, 30, 31, 32) miteinander verbunden sind.

9. Aufnahmewiedergabekopf, dadurch gekennzeichnet, dass er mindestens eine Schaltvorrichtung gemäss einem der Ansprüche 1 bis 8 enthält.

10. Anzeigetafel, dadurch gekennzeichnet, dass sie mindestens eine Schaltvorrichtung gemäss einem der Ansprüche 1 bis 8 enthält.

**Claims**

1. Plug and socket device for electronic control of microcircuits (12), multiplexed in bidirectional connection with controlled elements (11), characterized in that it comprises:
— a flexible hybrid circuit (14) for a single level of conductors (13, 18);
— a plurality of electronic microcircuits (12), supported by the flexible circuit and joined to connections (13) towards the controlled elements (11);
— current feeds (18) of these microcircuits being distributed from a first microcircuit towards other microcircuits by a surface modification of the microcircuit transmitter capsules, that comprises the adjunction of a supplementary insulating layer (121), which disengages the pre-existing connection terminals (21, 23) on the surface of the microcircuit (12) and the adjunction of metallized bands (22), deposited on the insulating layer, forming a bridge between an input terminal (21) and an output terminal (23) of each microcircuit.

2. Plug and socket device according to claim 1, characterized in that the metallic bridges (22), at the surface of the microcircuits, are in ohmic connection by at least one connecting terminal (21) with the active elements of microcircuit (12).

3. Plug and socket device according to claim 3, characterized in that the metallic bridges (22) at the surface of the microcircuits are insulated from the active elements of the microcircuits and interconnect between each other two connecting terminals, one input, the other output, insulated from the microcircuit.

4. Plug and socket device according to claim 1, characterized in that the control microcircuits (12) are integrated circuits.

5. Plug and socket device according to claim 1, characterized in that the controlled elements (11) are heating resistances.

6. Plug and socket device according to claim 1, characterized in that the controlled elements (11) are photodiodes.

7. Plug and socket device according to claim 1, characterized in that the controlled elements (11) are plasma diodes.

8. Plug and socket device according to claim 1, characterized in that, with a view to forming controlled element assemblies, with multiplexing of the flexible hybrid circuits (14) with a single level of conductors, the distribution circuits (25, 26, 27) are cut diagonally at one of their extremities, placed on a feed circuit (28) which is perpendicular to them and the metallic conductors (29, 30, 31, 32) are united, one to another, by means of a metallic connection (33).

9. A write-read head, characterized in that it comprises at least one plug and socket device according to one of claims 1 to 8.

10. Data presentation panel, characterized in that it comprises at least one plug and socket device according to one of claims 1 to 8.

FIG.1

FIG. 2

# FIG.3

# FIG.4